# EUROPEAN PATENT APPLICATION

(11) **EP 2 403 014 A1**
(43) Date of publication of application: **04.01.2012**
(21) Application number: 11172077.7
(22) Date of filing: 30.06.2011
(51) Int. Cl.: H01L 31/18

(54) **Transparent electrically conductive layer and method for forming same**

(30) Priority: 01.07.2010 US 828378
(71) Applicant: PrimeStar Solar, Inc, Arvada, CO 80004 (US)
(72) Inventor: Frey, Jonathan Mack, Arvada, CO 80004 (US)
(74) Representative: Bedford, Grant Richard

(57) **Abstract**

A method for forming a transparent electrically conductive layer. The method includes providing a layer comprising cadmium, tin, and oxygen. Concentrated electromagnetic energy (503) is directed from an energy source (501) to at least one portion of the layer to locally heat the at least a portion of the layer. The layer is crystallized to a cadmium-tin oxide ceramic. A photovoltaic cell (107) having the laser crystallized cadmium-tin oxide ceramic and a composition of matter are also disclosed.

## Description

The present invention is directed generally to transparent conductive layers for use with photovoltaic modules.

Energy demand is constantly increasing. As the energy demand increases, sources alternative to fossil fuel energy sources increase in importance. One such alternative energy source is solar energy. Generally, solar energy is produced by converting radiation (for example, sunlight) into electricity which may be stored or transmitted through electrical power grids.

Transparent conductive oxides (TCOs) are used as electrically conductive layers for the electrical contact of thin film photovoltaic (PV) cells in a PV module on a side that receives sunlight during operation. One type of TCO includes cadmium stannate. In preparation of a PV module cadmium stannate may be crystallized to reduce the sheet resistance and increase the optical transmission or transparency. To provide the desired properties of the TCO, the cadmium stannate film is annealed according to a known process to crystallize cadmium stannate film and provide increased transparency and conductivity. Currently, a vacuum annealing furnace is required in the recrystallization process.

A method for crystallizing transparent conductive thin films, such as cadmium stannate, for use in PV modules that do not require vacuum annealing or vacuum annealing equipment would be welcome in the art.

One embodiment of the present disclosure includes a method for forming a transparent electrically conductive layer. The method includes providing a layer comprising cadmium, tin, and oxygen. Directing concentrated electromagnetic energy from an energy source to at least a portion of the layer to locally heat the at least one portion of the layer. The layer is crystallized to a cadmium-tin oxide ceramic.

Another embodiment of the present disclosure includes a PV cell having a conductor layer comprising a laser crystallized cadmium-tin oxide ceramic.

Still another embodiment of the present disclosure includes a composition of matter including a transparent, electrically conductive crystallized cadmium-tin oxide ceramic formed from localized irradiation from concentrated electromagnetic energy from a laser.

Various aspects and embodiments of the present invention will now be described in connection with the accompanying drawings, in which:
FIG. 1 shows a thin film module mounted on a base according to the disclosure.
FIG. 2 is a diagram of a layer system making up cells of a module according to the disclosure.
FIG. 3 is a process flow diagram for an exemplary process for forming a module according to the disclosure.
FIG. 4 is a process flow diagram for an exemplary process according to the disclosure.
FIG. 5 shows an apparatus for performing the method according to the disclosure.
FIG. 6 shows an exemplary method for performing the method according to the disclosure.
FIG. 7 shows another exemplary method for performing the method according to the disclosure.
FIG. 8 shows an X-ray diffraction pattern for a vacuum annealed cadmium stannate layer.
FIG. 9 shows an X-ray diffraction pattern for a laser crystallized cadmium stannate layer.

Wherever possible, the same reference numbers will be used throughout the drawings to represent the same parts.

Provided is a method for crystallizing transparent conductive thin films, such as cadmium stannate, for use in PV modules that do not require vacuum annealing or vacuum annealing equipment. Suitable films for use with the present disclosure can be thin film for displays, PV modules, low e-glass, or other devices requiring transparent, electrically conductive contacts.

One advantage of the present disclosure includes a conductor layer having increased electrical conductivity. Another advantage of the present disclosure includes a transparent conductor layer having greater transparency and being able to receive more light.

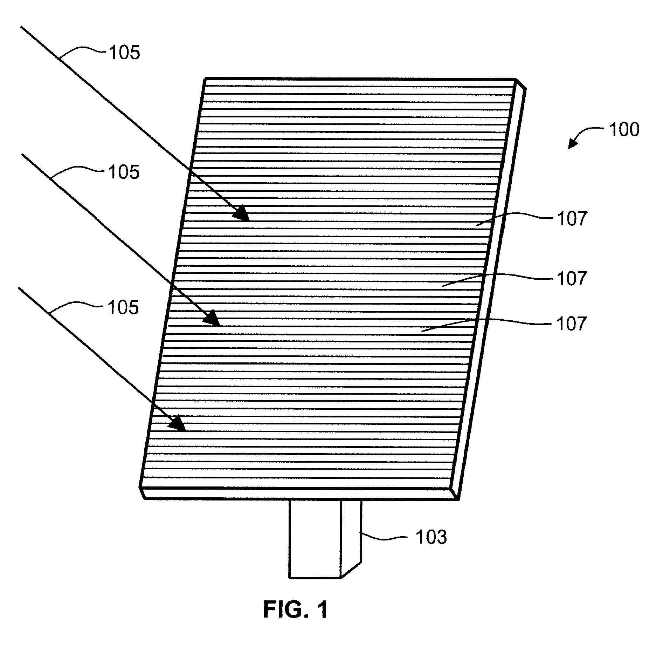

FIG. 1 shows a thin film PV module 100 mounted on a base 103. The PV module is arranged to receive light 105. The PV module is divided into a plurality of cells 107 that are arranged in series. The cells 107 are divided by spaces, non-conductive material and/or other structures separating circuits. For example, cells 107 may be isolated from each other by scribes formed by laser scribing. When the PV module 100 is exposed to light 105, electricity is produced. The disclosure is not limited to the arrangement shown and may include other mounting arrangements and/or cells 107. For example, the cells 107 may be oriented along the long dimension of module 100 instead of the short dimension of module 100. One embodiment of the disclosure includes a thin film CdTe solar photovoltaic (PV) module. Such modules are used to produce solar electricity for numerous applications, for example, large ground-mounted systems and rooftop systems on commercial and residential buildings.

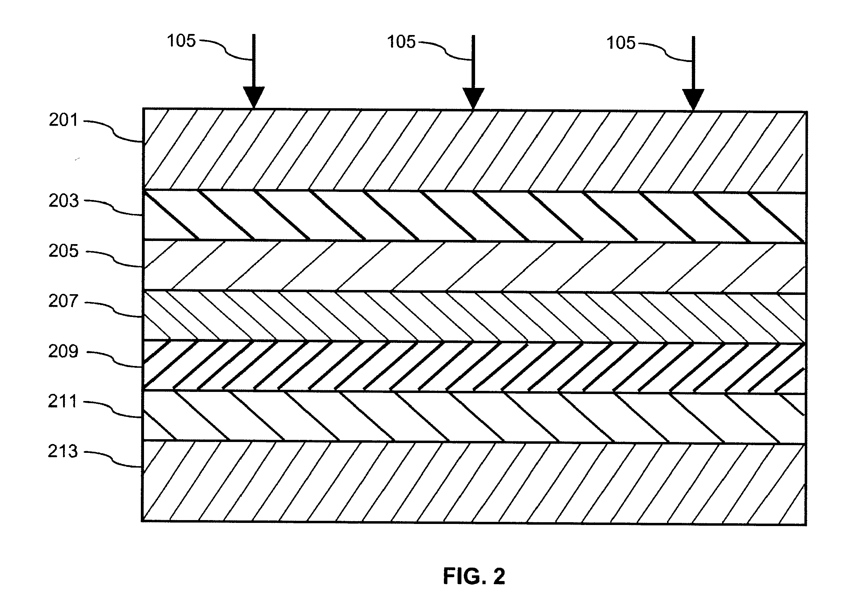

FIG. 2 is a diagram of the layer system forming cells 107 of PV module 100. The layers of cell 107 include a superstrate 201, a first conductive layer 203, a buffer layer 205, a first semiconductor layer 207, a second semiconductor layer 209, a second conductive layer 211 and an encapsulating glass 213. The layers of the cell 107 are arranged to generate and conduct electricity in a usable form when exposed to light 105.

The superstrate 201 is a sheet of high transmission glass onto which thin films are grown. The superstrate 201 receives light 105 (see e.g., FIG. 1) prior to the underlying layers. Superstrate 201 may be a high-transmission, low-iron float glass or any other suitable glass material having a high transmission rate for light 105. In another embodiment, the superstrate 201 may also be a high transmission borosilicate glass. After the light 105 passes through superstrate 201, at least a portion of the light passes through first conductive layer 203. First conductive layer 203 may be a transparent conductive oxide (TCO), which permits transmission of light 105 with little or no absorption. The first conductive layer 203 is also electrically conductive, which permits electrical conduction to provide the series arrangement of cells 107. The first conductive layer 203 is formed to a thickness that provides electrical conductivity, but permits the passage of at least some light 105. While not so limited, in one embodiment, the first conductive layer 203 may be formed to a thickness of about 300-500 nm, with up to a thickness of about 0.1-0.65 µm or about 0.15-0.3 µm. One suitable material for use in formation of the first conductive layer may be stoichiometric cadmium stannate (nominally CdSnO₃ or Cd₂SnO₄,).

Other suitable first conductive layers 203 may include fluorine-doped tin oxide, aluminum-doped zinc oxide, indium tin oxide, doped indium oxide, zinc or cadmium doped tin oxide, copper aluminum oxides or another compound of cadmium-tin oxide (such as CdSnO₃). First conductive layer 203 may permit passage of light 105 through to the semiconductor layers (e.g., first semiconductor layer 207 and second semiconductor layer 209) while also functioning as an ohmic electrode to transport photogenerated charge carriers away from the light absorbing material.

A buffer layer 205 is adjacent to first conductive layer 203. Buffer layer 205 is more electrically resistive and protects the layers of cell 107 from chemical interactions from the glass and/or interactions which might be incurred from subsequent processing. Inclusion of buffer layer 205 reduces or prevents electrical or other losses that may take place across cell 107 and across module 100. Suitable materials for buffer layer 205 may include tin oxide containing materials, such as, but not limited to, zinc doped tin oxide, a mixture of zinc and tin oxides (for example zinc tin oxide having 0.5 to 33 atomic % Zn), zinc stannate, gallium oxide, aluminum oxide, silicon oxide, indium oxide, cadmium oxide and any other suitable barrier material having more electrical resistivity than first conductive layer 203 and the capability of protecting the layers of the cell 107 from interactions from the glass or interactions from subsequent processing. In addition, the inclusion of buffer layer 205 permits the formation of a first semiconductor layer 207 which permits photon passage while maintaining a high quality junction capable of generating electricity. In certain embodiments, buffer layer 205 may be omitted or substituted by another material or layer. In one embodiment, buffer layer 205 includes a combination of ZnO and SnO₂. For example, in one embodiment, the buffer layer 205, while not so limited, may be formed to a thickness of up to about 1.5 microns or about 0.8-1.5 microns and may include ZnO and SnO₂ in a ratio (ZnO:SnO₂) of about 0:1 1 to about 2:1.

As shown in FIG. 2, first semiconductor layer 207 is adjacent to buffer layer 205 and receives light 105 subsequent to superstrate 201, first conductive layer 203 and buffer layer 205. First semiconductor layer 207 includes a wide bandgap n-type semiconductor material. Suitable semiconductor material for first semiconductor layer 207 includes, but is not limited to CdS, SnO₂, CdO, ZnO, AnSe, GaN, In₂O₂, CdSnO, ZnS, CdZnS or other suitable n-type semiconductor material. In one embodiment, the first semiconductor layer 207 includes CdS. While not so limited, first semiconductor layer 207 may have a thickness from about 0.01 to 0.3 µm or about 0.01 to about 0.1 µm. First semiconductor layer 207 may be formed by chemical bath deposition or by sputtering. First semiconductor layer 207 preferably has a smooth surface and is substantially uniform and free of impurities and pinholes.

First semiconductor layer 207 forms the junction with a second semiconductor layer 209 to create the photovoltaic effect in cell 107, allowing electricity to be generated from light 105. Second semiconductor layer 209 may include, for example, Cd, CdTe or other p-type semiconductor material. When second semiconductor layer 209 is provided with first semiconductor layer 207 a photovoltaic effect results when exposed to light 105.

As shown in FIG. 2, second semiconductor layer 209 is adjacent to first semiconductor layer 207. A second conductive layer 211 is adjacent to the second semiconductor layer 209 and provides an electrically conductive material that is capable of conducting electricity formed from the combination of the first semiconductor layer 207 and second semiconductor layer 209 when exposed to light 105. Although FIG. 2 shows an arrangement of two layers for first semiconductor layer 207 and second semiconductor layer 209, any number of layers, including interstitial layers, may be utilized to provide the photovoltaic effect.

Second conductive layer 211 may be fabricated from any suitable conductive material and combinations thereof. For example, suitable materials may include, but are not limited to, graphite, metallic silver, nickel, copper, aluminum, titanium, palladium, chrome, molybdenum alloys of metallic silver, nickel, copper, aluminum, titanium, palladium, chrome, and molybdenum and any combination thereof. In one embodiment, second conductive layer 211 may be a combination of graphite and nickel and aluminum alloys.

An encapsulating glass 213 may be adhered adjacent to second conductive layer 211. Encapsulating glass 213 may be a rigid structure suitable for use with the thin films of cell 107. Encapsulating glass 213 may be the same material as superstrate 201 or may be different. In addition, although not shown in FIG. 2, encapsulating glass 213 may include openings or structures to permit wiring and/or connection to cell 107.

Module 100 and individual cells 107 may include other layers and structures not shown in FIG. 2. For example, superstrate 201 and/or encapsulating glass 213 may include a barrier coating or other structure in order to reduce or prevent diffusion of impurities into the layers. In addition, encapsulating glass 213 may include an adherent layer to adhere encapsulating glass 213 to the layers. Additional structures that may be present in module 100 and/or cells 107 include, for example, scribes, bussing structures, external wiring, and various conventional components useful with thin film and/or PV structures.

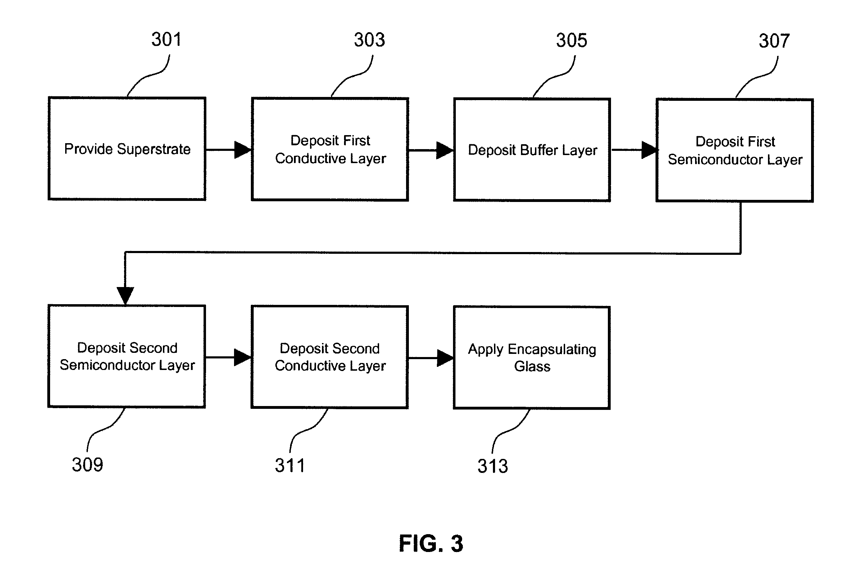

FIG. 3 shows a process flow diagram for an exemplary process for forming module 100. The process includes the formation of a thin film stack forming cell 107, wherein the films or layers are formed on superstrate 201 (shown from the top down in FIG. 2).

As shown in the flow diagram of FIG. 3, superstrate 201 is provided (box 301). Superstrate 201 may be fabricated from any suitable material capable of receiving thin films for use as PV cells and sufficiently transparent to allow transmission of light 105.

Subsequent to providing superstrate 201, first conductive layer 203 is deposited onto superstrate 201 (box 303). First conductive layer 203 is electrically conductive, which permits electrical conduction to provide the series arrangement of cells 107. While not so limited, in one embodiment, first conductive layer 203 may be formed to a thickness of about 0.1-0.6 µm or about 0.15-0.3 µm of stoichiometric cadmium stannate (nominally Cd₂SnO₄). Other suitable first conductive layers 203 may include fluorine-doped tin oxide, aluminum-doped zinc oxide, indium tin oxide, doped indium oxide, zinc or cadmium doped tin oxide, copper aluminum oxides or another compound of cadmium-tin oxide (such as CdSnO₃). First conductive layer 203 can be formed, for example by direct current (DC) or radio refrequency (RF) sputtering. In one embodiment, first conductive layer 203 is a layer of substantially amorphous Cd₂SnO₄ that is sputtered onto superstrate 201. Such sputtering can be performed from a hot-pressed target containing stoichiometric amounts of SnO₂ and CdO onto superstrate 201. While not so limited, the sputtering may provide SnO₂ and CdO onto superstrate 201 in a ratio (Cd:Sn) of about 0:1 1 to about 2:1. The cadmium stannate can alternately be prepared using cadmium acetate and tin (II) chloride precursors by spray pyrolysis.

Once first conductive layer 203 is applied, buffer layer 205 may be applied to first conductive layer 203 (box 305). In one embodiment, buffer layer 205 may be formed, for example, by sputtering. In one example, buffer layer 205 may be formed by sputtering from a hot-pressed target containing stoichiometric amounts of about 67 mol % SnO₂ and about 33 mol % ZnO onto first conductive layer 203. When deposited by sputtering, the zinc tin oxide material for buffer layer 205 may be substantially amorphous. Buffer layer 205 may have a thicknesses of between about 200 and 3,000 Angstroms, or between about 800 and 1,500 Angstroms, in order to have desirable mechanical, optical, and electrical properties. Buffer layer 205 may have a wide optical bandgap, for example about 3.3 eV or more, in order to permit the transmission of light 105.

First semiconductor layer 207 is deposited on buffer layer 205 (box 307). In one embodiment, first semiconductor layer 207 may be formed, for example, by chemical bath deposition or sputtering. While not so limited, first semiconductor layer 207 may be deposited to the thickness of from about 0.01 to 0.3 µm or about 0.01 to 0.1 µm. One suitable material for use as first semiconductor layer 207 is CdS. A suitable thickness for a CdS layer may range from about 500 to 800 Angstroms. First semidconductor layer 207 forms the junction with second semiconductor layer 209 to create the PV effect in cell 107, allowing it to generate electricity from light 105.

After the formation of first semiconductor layer 207, second semiconductor layer 209 is deposited on first semiconductor layer 207 (box 309). Second semiconductor layer 209 may include Cd, CdTe or other p-type semiconductor material. Second semiconductor layer 209 may be deposited by diffusive transport deposit, sputtering or other suitable deposition method for depositing p-type semiconductor thin film material.

Subsequent to the formation of the second semiconductor layer 209, second conductive layer 211 is formed (box 311). Second conductive layer 211 may be fabricated from any suitable conductive material. Second conductive layer 211 may be formed by sputtering, electrodeposition, screen printing, physical vapor deposition (PVD), chemical vapor deposition (CVD) or spraying. In one embodiment, second conductive layer 211 is a combination of graphite that is screen printed onto the surface and nickel and aluminum alloy that is sputtered thereon.

All the sputtering steps described above may be magnetron sputtering at ambient temperature under highly pure atmospheres. However, other deposition processes may be used, including higher temperature sputtering, electrodeposition, screen printing, physical vapor deposition (PVD), chemical vapor deposition (CVD) or spraying. In addition, the processing may be provided in a continuous line or may be a series of batch operations. When the process is a continuous process, the sputtering or deposition chambers are individually isolated and brought to coating conditions during each coating cycle, then repeated.

Once second conductive layer 211 is formed, encapsulating glass 213 is adhered to second conductive layer 211 (box 313). Encapsulating glass 213 may be a rigid material suitable for use with thin film structures and may be the same material or different material than superstrate 201. Encapsulating glass 213 may be adhered to second conductive layer 211 using any suitable method. For example, encapsulating glass 213 may be adhered to second conductive layer 211 using an adhesive or other bonding composition.

Although not shown in FIG. 3, other processing steps may be included in the process for forming module 100 and cells 107. For example, cleaning, etching, doping, dielectric or other selective insulative material deposition, formation of interstitial layers, scribing, heat treatments, and wiring may also be utilized. Wiring and/or bussing devices may be provided to complete the PV circuit (i.e., cells 107 in series arrangement) and to provide connectivity of the PV circuit to a load or other external device.

Scribing may be utilized to form the interconnections between the layers and isolated cells and/or layers of the thin film stack. Scribing may be accomplished using any known technique for scribing and/or interconnecting the thin film layers. In one embodiment, scribing is accomplished using a laser directed at one or more layers from one or more directions. One or more laser scribes may be utilized to selectively remove thin film layers and to provide interconnectivity and/or isolation of cells 107. In one embodiment, the scribes and layer deposition are accomplished to interconnect and/or isolate cells 107 to provide a PV circuit having cells 107 in a series of electrical arrangements.

In one embodiment of the present disclosure, cadmium-tin oxide ceramic 511 is formed on or within the first conductive layer 203. The cadmium-tin oxide ceramic 511 is an area in which the material of the first conductive layer 203 is at least partially crystallized. The cadmium-tin oxide ceramic 511 may be located along the first conductive layer 203 or may include the entire surface or entire bulk of first conductive layer 203. The cadmium-tin oxide ceramic 511 includes a greater transparency and a greater electrical conductivity than cadmium stannate.

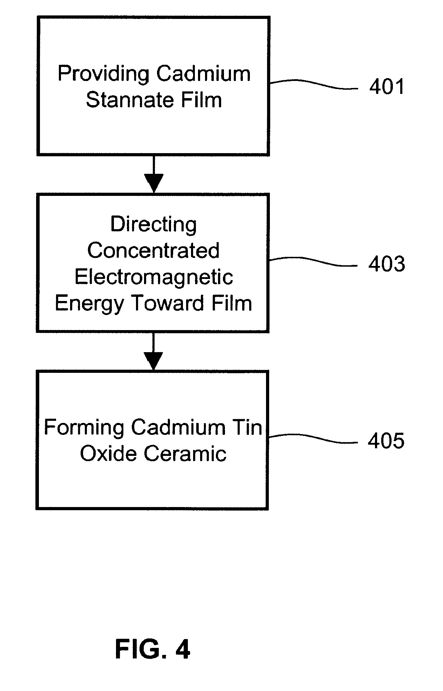

FIG. 4 includes a flowchart illustrating an exemplary method for forming cadmium-tin oxide ceramic 511. First conductive layer 203 may be a transparent conductive oxide (TCO) of cadmium stannate, including stoichiometric cadmium stannate (nominally Cd₂SnO₄,) having, for example, a 2:1:4 (Cd:Sn:O) atomic ratio and cadmium stannate spinel crystal structure. The method includes providing a cadmium stannate film (box 401). The cadmium stannate film may, for example, be a first conductive layer 203 for a PV module. The cadmium stannate film includes cadmium, tin and oxide as a compound or mixture of compounds, such as cadmium stannate. In addition, the cadmium stannate film may include additives and/or impurities for forming a transparent first conductive layer 203. The method further includes directing concentrated electromagnetic energy or beam 503 from an energy source 501 toward the cadmium stannate film (box 403). Suitable energy sources may include, but are not limited to, laser, radio frequency (Rf), electron beam, infrared (IR) or source for rapid thermal process/anneal (RTA). The laser or other energy source 501 is configured to generate concentrated electromagnetic energy 503 with a power density and/or wavelength that provides heat and/or other suitable energy to the cadmium stannate film. The term "concentrated electromagnetic energy" includes directed energy in any suitable form and may include, but is not limited to, laser beams, directed Rf energy, electron beams, directed IR energy or any other directed or concentrated energy capable of providing energy to a surface 505. The heat and/or other suitable energy may be sufficient to provide crystallization of the film upon cooling. In one embodiment the energy source may be a laser emitting concentrated electromagnetic energy 503 having a wavelength of 100-1500 nm and a fluence of from about 0.01 J/cm² to about 1 J/cm² or about 0.1 J/cm². The method further includes crystallizing the cadmium stannate film to form cadmium-tin oxide (box 405). The cadmium-tin oxide ceramic 511 includes an electrical conductivity and transparency that is greater than the conductivity (i.e., lower than the resistivity) of the cadmium stannate film. For example, the resistivity of the cadmium-tin oxide ceramic 511 may be as low as 5 ohm/square or from about 10 ohms/square to about 5 ohms square. In another embodiment, the first conductive layer 203 may be a TCO of zinc stannate, including a stoichiometric zinc stannate (nominally Zn₂SnO₄,) having, for example, a 2:1:4 (Zn:Sn:O) atomic ratio and zinc stannate inverse spinel crystal structure.

While the process above has been shown and described as directing concentrated electromagnetic energy or beam 503 from an energy source 501 toward the cadmium stannate film directly, the process is also suitable for through-glass processes. Exemplary through-glass processes may providing laser or other concentrated electromagnetic energy incident to a cadmium stannate film after passing through glass or other transparent article.

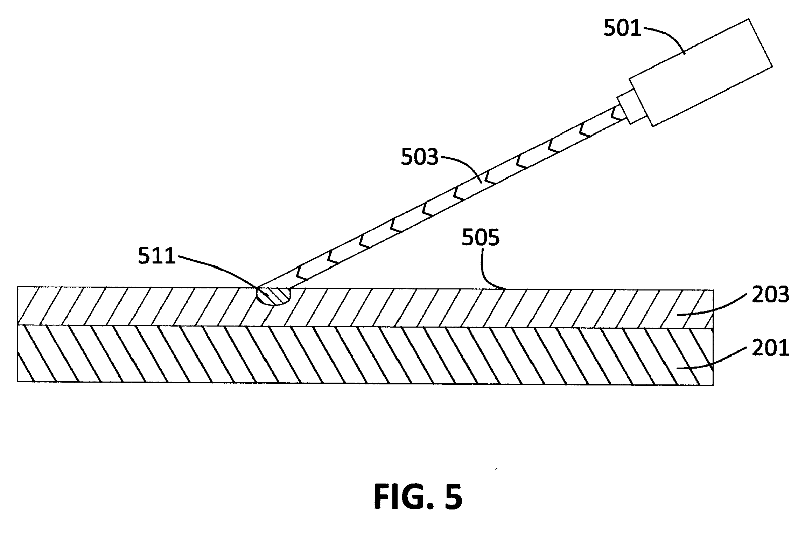

FIG. 5 illustrates an apparatus for forming the cadmium-tin oxide ceramic 511 as shown and described in FIG. 4. As shown in FIG. 5, an energy source 501 emits concentrated electromagnetic energy 503 that is directed at surface 505 of first conductive layer 203. In one embodiment, first conductive layer 203 comprises cadmium, tin and oxygen that may be in the form of cadmium stannate. The energy source 501 is an energy source capable of providing sufficient heat and/or other suitable energy to the surface of the first conductive layer 203 to crystallize the cadmium, tin and oxide in the first conductive layer 203 upon cooling. In one embodiment, the energy source 501 is a laser that emits concentrated electromagnetic energy 503 having a wavelength of from about 100-1500 nm. Suitable wavelengths includes 226 nm, 350 nm, 532 nm and 1064 nm. Pulse durations of the laser range from 1 ns to 500 ns. In addition, the laser may include a beam having fluence of from about 0.01 J/cm² to about 1 J/cm² or about 0.1 J/cm². When concentrated electromagnetic energy 503 contacts the surface 505, the first conductive layer 203 is locally heated at the location at which the concentrated electromagnetic energy 503 contacts the surface 505. In one embodiment, the heat generated may be sufficient to locally form a cadmium-tin oxide ceramic 511 having multiple crystal phases upon cooling. The cadmium-tin oxide ceramic includes a plurality of crystal phases that form when the cooling takes place. The atmosphere in which the cadmium stannate is treated may be ambient gas compositions such as air, CO, N₂:H₂ (forming gas), O₂, and combinations thereof.

While not wishing to be bound by theory, it is believed that the localized temperature differential at the point of irradiation by the concentrated electromagnetic energy 503 from the energy source 501 and high quench rate results in the combination of crystal phases. The process of the various aspects of the present invention utilizes quench rates on the order of nanoseconds.

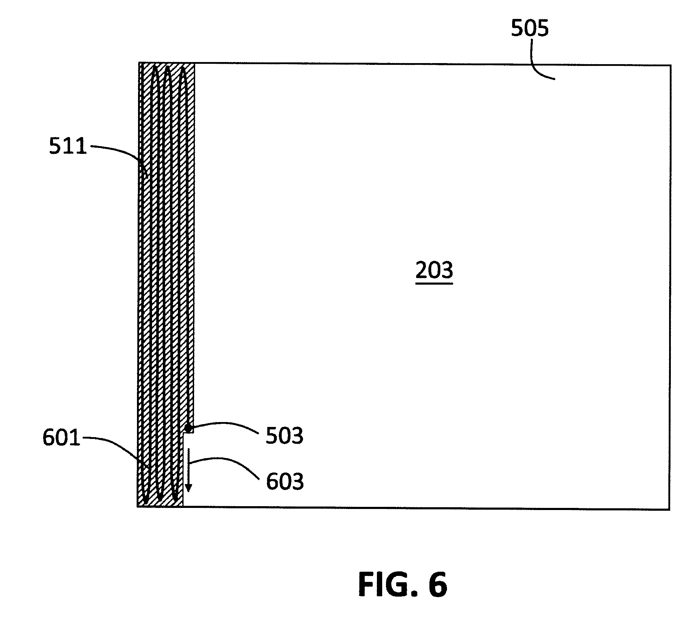

FIG. 6 shows a top view of a first conductive layer 203 comprising cadmium, tin, and oxygen, being subjected to the method of the present disclosure. As shown, concentrated electromagnetic energy 503 from a laser is traced along path 601 locally heating the surface 505 of first conductive layer 203. After the concentrated electromagnetic energy 503 heats the surface 505, the surface cools and the first conductive layer 203 is crystallized to form cadmium-tin oxide ceramic 511. The embodiment shown in FIG. 6 includes a path 601 that traces back and forth across the surface 505 in a direction 603. However, the path 601 of concentrated electromagnetic energy 503 is not so limited and may include any suitable path 601 for concentrated electromagnetic energy 503.

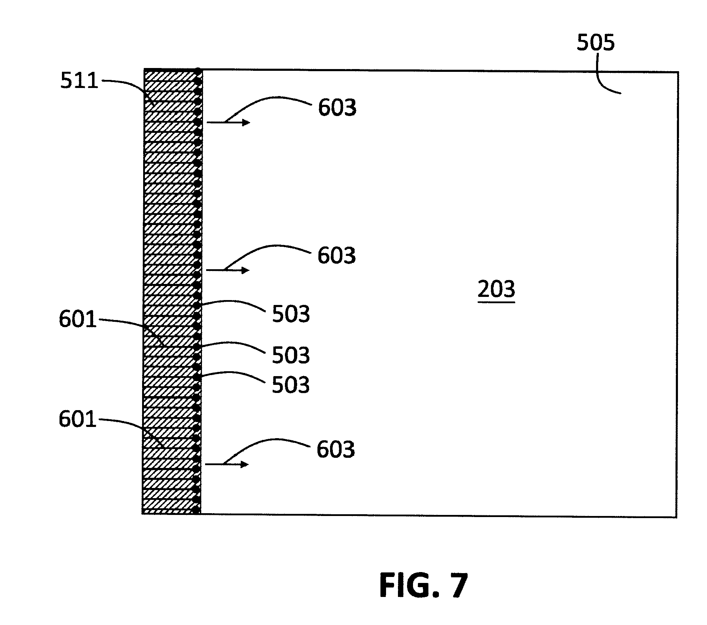

FIG. 7 shows an alternate arrangement, wherein a plurality of beams of concentrated electromagnetic energy 503 are utilized to simultaneously crystallize the surface 505 of the first conductive layer 203. In this embodiment, the concentrated electromagnetic energy 503 may provide the treatment in a single pass in direction 603, which reduces the process time required. Like in the embodiment of FIG. 6, the first conductive layer 203 is crystallized to form cadmium-tin oxide ceramic 511 along path 601 of concentrated electromagnetic energy 503. In one embodiment, the sheet resistance due to crystallization decreases by up to about 70% or up to about 60% or up to about 50%. For example, the resistivity of the cadmium-tin oxide ceramic 511 may be as low as 5 ohm/square or from about 10 ohms/square to about 5 ohms square. In certain embodiments, the resistivity may be reduced from about 50 ohm/square to about 20 ohm/square or from about 20 ohm/square to about 8 ohm/square. In addition, the transparency of the cadmium-tin oxide ceramic 511 is greater than the transparency of a TCO containing first conductive layer 203.

### EXAMPLES

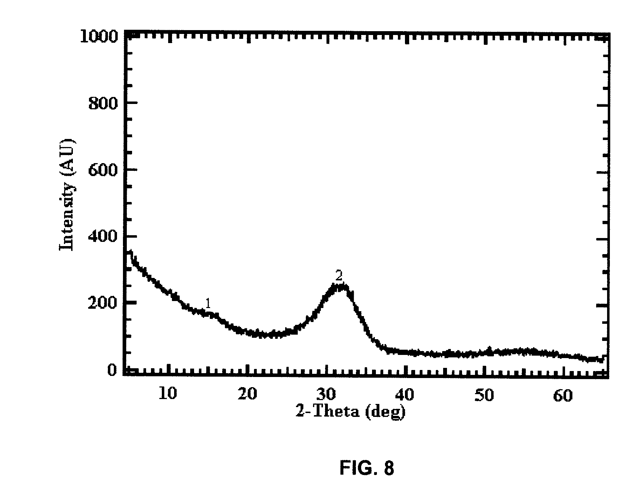

Comparative Example: A cadmium stannate film was recrystallized by vacuum annealing according to a known method of a post-deposition heat treatment for 10 minutes at 650° C (1202° F) in helium. X-ray diffraction data for the Comparative Example was obtained and is shown in FIG. 8.

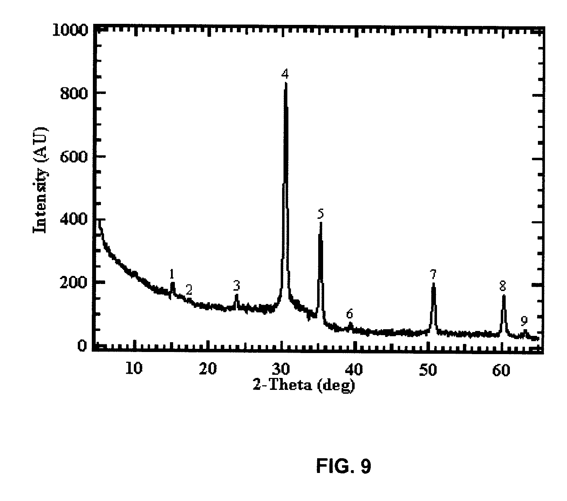

Example 1: An exemplary cadmium stannate film was recrystallized using a laser having a wavelength of approximately 1070 nm. X-ray diffraction data for the Example was obtained and is shown in FIG. 9. As shown in FIG. 9, the cadmium stannate subjected to the localized laser annealing showed significant local crystallization of the cadmium stannate where the laser was incident upon it. As shown in FIGs. 8 and 9, a different combination of crystal phases results when the localized heating of the present disclosure is performed compared to the process of vacuum annealing.

In Example 1, initial sheet resistances were -50 Ohm/Sq and -20 Ohm/Sq, respectively. After laser induced crystallization, the sheet resistances were lowered to approximately -20 Ohm/Sq and 7.5 Ohm/Sq as measured by a four point probe method. Using an optical transmission measuring system, it was also shown that the transmission of such films increased.

The compositions of the test sample of Example 1 in regions of the film including laser exposed portions and portions that were not exposed to the laser are as follows:

| **Element** | **General α-x** | **Region α-y** | **Region α-z** |
|---|---|---|---|
| Sn | 12.41 | 12.49 | 12.47 |
| Cd | 5.71 | 5.65 | 5.68 |
| Zn | 0.00 | 0.00 | 0.00 |
| O | 71.32 | 71.40 | 70.88 |
| Si | 8.93 | 8.90 | 9.19 |
| Ca | 1.63 | 1.57 | 1.78 |

As shown above the elemental composition of the treated and untreated areas of Example 1 are substantially identical. Example 2: An exemplary cadmium stannate film was recrystallized using a laser having a wavelength approximately 532. A reduction in sheet resistance and absorption substantially identical to Example 1 were obtained.

Described below are example methods for laser treatment of cadmium stannate thin films according to the present disclosure.

Example 3: Two Pass Method Example:

The two pass method has been shown to crystallize initially amorphous cadmium stannate thin films.

A laser beam is rastered at a slow scan speed across the film-side or glass-side of an amorphous cadmium stannate thin film. The raster occurs through two passes, between which an angular difference is induced on the scan direction, thereby increasing uniformity of irradiation coverage.

### 1^{st} Pass @ 0 Degree Angle

Fluence: 0.19 J/cm^2
Pulse Duration: ~150ns
PRF: 80kHz
Wavelength: 1070nm
Scan Velocity: 50mm/s
Scan Separation: 100um

### 2^{nd} Pass @ 90 Degree Angle

Fluence: 0.19 J/cm^2
Pulse Duration: ~150ns
PRF: 80kHz
Wavelength: 1070nm
Scan Velocity: 50mm/s
Scan Separation: 100um

The resultant film of Example 3 includes a cadmium-tin oxide ceramic film having an increased transparency and increased electrical conductivity.

Example 4: Multipass methods are performed using the initial laser configuration of Example 1. In each consecutive pass, the fluence is increased incrementally to compensate for the increased transmission (decreased absorption) of the laser. The resultant film includes a cadmium-tin oxide ceramic film having an increased transparency and increased electrical conductivity. Cadmium Stannate can achieve sheet resistances on the order of 5-10 ohm/square. The laser annealed cadmium-tin oxide material has a similar range of about 7.8 ohm/square.

Example 5: A conductive tin oxide was deposited on a low iron glass. The conductive tin oxide had an initial resistivity of about 50 ohm/sq. Subsequent to exposure to the laser, the resistivity was about 20 ohm/sq.

Example 6: A heated conductive tin oxide was deposited on a low iron glass. In this example, the initial resistivity was about 20 ohm/sq. Subsequent to exposure to the laser, the resistivity was 7.8 ohm/sq.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

Various aspects and embodiments of the present invention are defined by the following numbered clauses:
1. A method for forming a transparent electrically conductive layer, the method comprising:
   providing a layer comprising cadmium, tin, and oxygen;
   directing concentrated electromagnetic energy from an energy source to at least a portion of the layer to locally heat the at least a portion of the layer; and
   crystallizing the layer to a cadmium-tin oxide ceramic.
2. The method of clause 1, wherein the energy source is selected from the group consisting of laser, radio frequency, electron beam, infrared, rapid thermal process/anneal and combinations thereof.
3. The method of any preceding clause, wherein the energy source is a laser.
4. The method of any preceding clause, wherein the energy source includes a wavelength of from about 100 nm to about 1500 nm.
5. The method of any preceding clause, wherein the energy source includes a wavelength selected from the group consisting of 266 nm, 350 nm, 532 nm, and 1064 nm.
6. The method of any preceding clause, wherein the layer is a first conductive layer of a photovoltaic cell.
7. The method of any preceding clause, wherein the cadmium-tin oxide ceramic has a greater transparency than the layer.
8. The method of any preceding clause, wherein the cadmium-tin oxide ceramic has a greater electrical conductivity than the layer.
9. The method of any preceding clause, wherein the cadmium-tin oxide ceramic has an electrical conductivity of at least 50% greater than the layer.
10. The method of any preceding clause, wherein the cadmium-tin oxide ceramic includes multiple crystal phases.
11. The method of any preceding clause, wherein the cadmium-tin oxide ceramic includes an X-ray diffraction pattern substantially the same as that shown in FIG. 9.
12. A photovoltaic cell comprising:
   a conductive layer comprising a laser crystallized cadmium-tin oxide ceramic.
13. The photovoltaic cell of any preceding clause, further comprising a superstrate, a buffer layer, a first semiconductor layer, a second semiconductor layer, a second conductive layer, and an encapsulating glass operably arranged to generate electricity.
14. The photovoltaic cell of any preceding clause, wherein the cadmium-tin oxide ceramic includes multiple crystal phases.
15. The photovoltaic cell of any preceding clause, wherein the cadmium-tin oxide ceramic includes an X-ray diffration pattern substantially the same as that shown in FIG. 9.
16. The photovoltaic cell of any preceding clause, wherein the cadmium-tin oxide ceramic has a greater transparency than cadmium stannate.
17. The photovoltaic cell of any preceding clause, wherein the cadmium-tin oxide ceramic has a greater electrical conductivity than cadmium stannate.
18. A composition of matter comprising:
   a transparent, electrically conductive crystallized cadmium-tin oxide ceramic formed from localized irradiation from concentrated electromagnetic energy from a laser.
19. The composition of any preceding clause, wherein the cadmium-tin oxide ceramic includes multiple crystal phases.
20. The composition of any preceding clause, wherein the cadmium-tin oxide ceramic includes an X-ray diffraction pattern substantially the same as that shown in FIG. 9.

## Claims

1. A method for forming a transparent electrically conductive layer, the method comprising:
providing a layer comprising cadmium, tin, and oxygen;
directing concentrated electromagnetic energy (503) from an energy source (501) to at least a portion of the layer to locally heat the at least a portion of the layer; and
crystallizing the layer to a cadmium-tin oxide ceramic.

2. The method of claim 1, wherein the energy source (501) is selected from the group consisting of laser, radio frequency, electron beam, infrared, rapid thermal process/anneal and combinations thereof.

3. The method of claim 2, wherein the energy source (501) is a laser.

4. The method of any preceding claim, wherein the energy source (501) includes a wavelength of from about 100 nm to about 1500 nm.

5. The method of any preceding claim, wherein the energy source (501) includes a wavelength selected from the group consisting of 266 nm, 350 nm, 532 nm, and 1064 nm.

6. The method of any preceding claim, wherein the layer is a first conductive layer (203) of a photovoltaic cell (107).

7. The method of any preceding claim, wherein the cadmium-tin oxide ceramic has a greater transparency than the layer.

8. The method of any preceding claim, wherein the cadmium-tin oxide ceramic has a greater electrical conductivity than the layer.

9. The method of any preceding claim, wherein the cadmium-tin oxide ceramic has an electrical conductivity of at least 50% greater than the layer.

10. The method of any preceding claim, wherein the cadmium-tin oxide ceramic includes multiple crystal phases.
